# EUROPÄISCHE PATENTANMELDUNG

(11) **EP 0 614 272 A1**
(43) Veröffentlichungstag der Anmeldung: **07.09.1994**
(21) Anmeldenummer: 94103068.6
(22) Anmeldetag: 01.03.1994
(51) Int. Cl.: H03H 9/64

(54) **Oberflächenwellen-Resonatorfilter**

(30) Priorität: 04.03.1993 DE 4306825
(71) Anmelder: SIEMENS AKTIENGESELLSCHAFT, D-80333 München (DE)
(72) Erfinder: Fleischmann, Bernd, Dipl.-Ing., D-83059 Kolbermoor (DE); Scholl, Gerd, Dipl.-Ing., D-80636 München (DE); Machui, Jürgen, Dipl.-Math., D-80809 München (DE); Du Hamél, André, D-15230 Frankfurt/Oder (DE)

(57) **Zusammenfassung**

Oberflächenwellenfilter mit mehreren Spuren (1 bis 4) mit in jeder Spur einem Eingangswandler (70) einem Ausgangswandler (71), einer ersten Reflektorstruktur (81) und einer zweiten Reflektorstruktur (70), wobei die Reflektorstrukturen einen Resonator bilden. Die Resonatoren der einzelnen Spuren (1 bis 4) sind auf nahe beieinanderliegende, voneinander verschiedene Frequenzen (f1 bis f4) abgestimmt und die Eingangswandler einerseits und die Ausgangswandler andererseits als Eingang und Ausgang des Filters parallelgeschaltet. Vorzugsweise ist die Positionierung und die Wahl der Phase für Eingangswandler und Ausgangwandler zueinander derart gewählt, daß direkter Wandler-Wandler-Transfer für Spurenpaare im Ausgang durch Interferenz eliminiert ist.

## Beschreibung

Die vorliegende Erfindung bezieht sich auf ein Oberflächenwellenfilter mit in wenigstens zwei Spuren angeordneten Oberflächenwellenstrukturen, wobei in einer jeden Spur wenigstens ein Eingangswandler, ein Ausgangswandler und eine Reflektorstruktur vorgesehen sind, die in inline-Anordnung zueinander angeordnet sind. Der Reflektor ist eine mit 180°-Ablenkung reflektierende Oberflächenwellenstruktur. Die Eingangswandler und die Ausgangswandler beider Spuren sind jeweils elektrisch parallelgeschaltet mit dem Eingang bzw. Ausgang des Filters verbunden.

Es ist bekannt ein kaskadiertes Filter mit Oberflächenwellenstrukturen aufzubauen. Dazu sind auf einem Substrat in der Achse der Wellenfortpflanzungsrichtung in dem Filter Eingangswandler, Ausgangswandler und Reflektorstrukturen angeordnet, und zwar derart, daß dort wenigstens zwei Resonatoren gebildet sind, die (schwach) miteinander gekoppelt sind. Es ergibt sich dann als Durchlaßkurve eine solche mit zwei nahe beieinanderliegenden Resonanzspitzen, die einem Bandfilterverlauf entsprechen können und dazu das Grundband mit vielen Nebenzipfeln.

Aus der DE-OS 39 42 140 ist ein Oberflächenwellenfilter mit den voranstehend genannten Merkmalen bekannt. Es handelt sich dort um ein mehrspuriges, insbesondere zweispuriges Reflektorfilter mit in jeder Spur inline-Anordnung von Eingangswandler/Ausgangswandler und Reflektorstruktur(-en), bei dem nichtselektives akustische Übersprechen vom Eingangswandler auf den Ausgangswandler für das Filter zusammengenommen minimiert ist. Es sind die Eingangswandler einerseits und die Ausgangswandler andererseits von zwei Spuren derart elektrisch miteinander verbunden, daß in diesen beiden Spuren gleiche Wellenanregung und Wellenauskopplung bewirkt ist. Fur die eine Spur ist gegenüber der anderen Spur der jeweilige direkte akustischen Wellentransfer zwischen Eingangswandler und Ausgangswandler, nämlich direkt vom Eingangswandler zum benachbarten Ausgangswandler, jedoch derart unterschiedlich gemacht, daß bei diesem direkten akustischen Wellentransfer bei (angenommen) gleichphasiger Wellenerzeugung durch die beiden Eingangswandler die beiden Ausgangswandler, nämlich der einen Spur und der anderen Spur, elektrisch zusammengeschaltet ein Ausgangssignal liefern, in dem kein dem direkten akustischen Wellentransfer entsprechender Signalanteil enthalten ist. Dies beruht darauf, daß der eine Ausgangswandler gegenüber dem anderen Ausgangswandler phasenentgegengesetztes akustisches Wellensignal empfängt und entsprechend phasenentgegengesetztes elektrisches Signal erzeugt. Dabei kann bekanntermaßen dieser 180° Phasenunterschied auf um ungeradzahlige Vielfache der halben Wellenlänge unterschiedlichem geometrischem Abstand zwischen den einander nächstgegenüberliegenden jeweils äußersten Fingern von Eingangswandler und Ausgangswandler in der einen Spur gegenüber der anderen Spur beruhen. Es kann dazu auch bekanntermaßen ein geometrisch gleich großer (oder nur um geradzahlige Vielfache der halben Wellenlänge unterschiedlicher) Abstand zwischen den jeweils zwei in einer Spur einander gegenüberliegenden Wandlern vorliegen und der eine Ausgangswandler ist gegenüber dem anderen Ausgangswandler (oder der eine Eingangswandler gegenüber dem anderen Eingangswandler) phasenentgegengesetzt mit dem elektrischen Filterausgang (Filtereingang) zusammengeschaltet.

In allen Fallen liegt bei einem solchen bekannten (und soweit auch bei einem weitergebildeten erfindungsgemäßen) Filter der Sachverhalt vor, daß die akustische Welle vom Eingangswandler zum Ausgangswandler allein über die Reflektorstruktur der jeweiligen Spur zwischen Eingangswandler und Ausgangswandler übertragen wird. Da die Reflektorstruktur als frequenzselektives Element wirksam ist, ist damit ein mit prinzipiell in jeder Spur inline-Aufbau realisiertes Filter vorhanden, dessen Durchlaßverhalten allein durch das frequenzselektive Verhalten der Reflektorstruktur bestimmt ist.

Mit der bekannten Anordnung lassen sich selektive und flankensteile, schon relativ schmalbandige Filter realisieren, bei denen zwangsläufig breitbandige direkte Übertragung zwischen Eingangs- und Ausgangswandler (=direkte Wandler-Wandlerübertragung; Grundpegel eliminiert bzw. minimiert ist und die Reflektorstruktur als die wesentliche, das Frequenzverhalten bestimmende Struktur ausgebildet und wirksam ist.

Ein wie aus der obengenannten Druckschrift bekanntes Filter zeichnet sich durch von der Länge der vorgesehenen Reflektorstruktur abhängige hohe Selektivität und Schmalbandigkeit aus. Die Größe des für ein solches Zweispurfilter erforderlichen Substrats ist in erster Linie durch die dazu erforderliche Länge der Reflektorstruktur(-en) bestimmt.

Aufgabe der vorliegenden Erfindung ist es, ein Filter anzugeben, bei dem mehr Freiheit hinsichtlich der Vorgabe einer gewünschten relativen Bandbreite und/oder Form der Durchlaßkurve mit dabei hoher Flankensteilheit geboten ist, und zwar dies ohne externe Koppelinduktivitäten. Dabei soll dieses Filter weniger Substratfläche benötigen als z. B. die bekannten Filter mit kaskadierten, gekoppelten Resonatoren. Insbesondere soll das Filter nur geringe Temperaturabhängigkeit aufweisen (z. B. Quarz verwendbar sein). Aufgabe einer Weiterbildung der Erfindung ist, daß das Filter eine hohe Sperrdämpfung, d. h. einen sehr niedrigen nichtselektiven Grundpegel, und insbesondere keine wesentlichen Nebenzipfel hat. Das Filter soll, bezogen auf die Flankensteilheit, relativ kleine Bandbreite mit aber dennoch vorzugsweise über ein Promille haben.

Diese Aufgabe der Erfindung wird mit einem Filter mit den Merkmal des Patentanspruches 1 gelöst. Die Unteransprüche betreffen Varianten bzw. eine Weiterbildung der Erfindung und weitere Ausgestaltungen .

Die generelle Lösung der gestellten Aufgabe besteht in einer synergetischen Kombination und Anordnung vorzugsweise speziell ausgewählter Ausführungsformen für Eingangswandler, Ausgangswandler und Reflektorstruktur (-en) der jeweils einen Spur eines insgesamt n-fach zweispurigen Filters, und zwar mit jeweils in-line-Anordnung in einer jeden der Spuren. Die Zahl n kann vorzugsweise gleich 1 sein.

Die Lösung der vorliegenden Erfindung ist an den bekannten 2-Tor-Resonator angelehnt. Eine erste Lösungsvariante der vorliegenden Erfindung besteht darin, eine Anzahl von 2-Tor-Resonatoren einander parallel zu schalten. Bei der Erfindung sind jedoch, insbesondere im Gegensatz zu einem bekannten kaskadierten gekoppelten Resonatorfilter, die Resonanzfrequenzen der Resonatoren der einzelnen 2-Tor-Resonatoren frequenzmäßig gegeneinander leicht verstimmt. Bei der Parallelschaltung von z. B. zwei 2-Tor-Resonatoren wird der eine 2-Tor-Resonator auf eine der gewünschten Bandmitte etwas niedrigere Frequenz abgestimmt und der andere 2-Tor-Resonator auf eine etwas höhere, vorzugsweise dazu symmetrische Frequenzlage eingestellt. Wichtig ist, daß sich bei der Erfindung die Phasen dieser beiden benachbarten Resonanzen um 180° voneinander unterscheiden. Die Eingänge der beiden 2-Tor-Resonatoren und auch deren zwei Ausgänge werden jeweils elektrisch miteinander parallel geschaltet, wobei diese Parallelschaltungen der elektrische Eingang und der elektrische Ausgang des ganzen erfindungsgemäßen Filters sind. Die geforderte 180°-Phasenverschiebung wird bei der Erfindung dadurch bewirkt, daß entweder die Ausgangswandler (Eingangswandler) der beiden 2-Tor-Resonatoren durch Vertauschung ihrer elektrischen Polung mit dem elektrischen Ausgang (Eingang) des Resonators phasenentgegengesetzt (vergleichsweise zum anderen 2-Tor-Resonator des Filters) angeschlossen ist, oder indem bei einem der beiden 2-Tor-Resonatoren die akustisch relevante Wegstrecke zwischen Eingangswandler und Ausgangswandler sich gegenüber der vergleichbaren Wegstrecke des anderen 2-Tor-Resonators um nahezu ein ungradzahliges Vielfaches der halben Wellenlänge der Oberflächenwelle unterscheidet.

Diese erfindungsgemäße Variante kann auch mit 3, 4 oder einer noch größeren Anzahl von 2-Tor-Resonatoren ausgeführt werden.

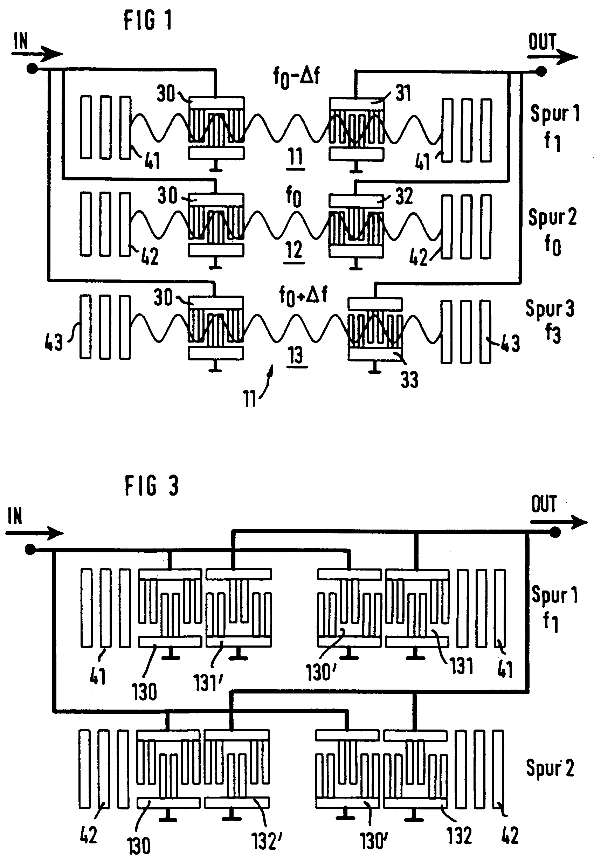

Die Fig. 1 zeigt ein erfindungsgemäßes, aus 3 Spuren bestehendes 2-Tor-Resonatorfilter 1, deren einzelne 2-Tor-Resonatoren 11, 12, 13 auf die Frequenzen f1 bis f3 abgestimmt sind.

Mit der Figur 2 ist eine Durchlaßkurve 10 für ein dreifaches 2-Tor-Resonatorfilter 1 der Fig. 1 prinzipiell wiedergegeben, aus dem die Verteilungen bzw. Verstimmungen der Frequenzen um die Bandmitte f0 ersichtlich ist. Für einen Filter mit einer noch größeren Anzahl Spuren empfiehlt sich entsprechende/sinngemäße symmetrische Verteilung der Frequenzen f1 bis fn und die Frequenz f0 herum, und zwar stets mit 180 ° Phase zwischen benachbarten Frequenzen.

In Fig. 1 sind die Resonatoren 11, 12 bzw. die Spuren 1 und 2 mit zueinander gegenphasig elektrisch angeschlossenen Ausgangswandler 31, 32 wiedergegeben. Der Resonator der Spuren 3 ist gegenüber dem der Spur 2 so ausgeführt, daß gleichphasiger Anschluß mit jedoch um nahezu λ/2 größerem Abstand zwischen Eingangswandler 30 und Ausgangswandler 33 vorliegt. Die gegenseitigen Phasenverschiebungen zwischen den jeweiligen Spuren mit den Frequenzen f1 bis f3 sind derart, daß zwischen benachbarten Resonanzfrequenzen stets jeweils 180° Phasenverschiebung vorliegt. Die Reflektoren sind 41, 42 und 43 bezeichnet.

Bei dieser Variante der Erfindung läßt sich durch entsprechende Anzahl 2-Tor-Resonatoren mit wie angegeben gegenseitiger Verstimmung der Resonanzfrequenzen die relative Bandbreite wesentlich größer machen, als dies für bekannte temperaturstabile Resonatorfilter ohne externe Koppelinduktivitäten erreichbar wäre.

Fig. 3 zeigt eine weitere Ausgestaltung einer Ausführungsform nach Fig. 1. Es sind dort jeweils Paare dicht nebeneinander angeordneter Eingangs- und Ausgangswandler 130/131'; 130'/131 in der einen Spur 1 und 130/132'; 130'/132 in der anderen Spur 2 vorgesehen sind. Das Zeichen ' weist auf jeweils gegenüber Fig. 1 um 180°-Phase veränderte Ausführung des betreffenden Wandlers hin.

Mit dieser (in der DE-OS 41 14 202 in anderem Zusammenhang beschriebenen) Ausgestaltung läßt sich zusätzlich bei einem Filter der ersten Variante dieser Erfindung (bzw. der Ausführung nach Fig. 1) erreichen, daß unerwünschte longitudinale Moden der Resonanz unterdrückt sind.

Eine zweite Variante bzw. Weiterbildung der Lösung der der Erfindung gestellten Aufgabe besteht darin, durch Wahl der Anordnung bzw. Ausfuhrung der Oberflächenwellenelemente in einer jeden Spur eines 2n-fach mehrspurigen Filters zu erreichen, daß auch der Grundpegel des nichtselektiven Signals minimiert ist. Aus der DE-OS 39 42 140 ist ein schon oben erläutertes Prinzip bekannt, mit dem diese Minimierung des nichtselektiv vom Eingangswandler auf den Ausgangswandler übertragenen Wellensignals zu erzielen ist. Für das ganze Filter gesehen, erhält die Parallelschaltung der Ausgangswandler das Ausgangssignal allein über jeweils eine die Selektivität bestimmende Oberflächenwellenstruktur, die bei diesem Stand der Technik für jede Spur die gleiche Reflektorstruktur ist. Jede Spur ist (damit) auf dieselbe Frequenz f0 abgestimmt.

Bei der zweiten Lösungsvariante der vorliegenden Erfindung wird jedoch von der Lehre der obengenannten DE-OS wesentlich abgewichen, nämlich indem der dort für die Spuren geforderte Lambdaviertel-Wegunterschied hier entfällt. Vielmehr werden bei der zweiten Variante der vorliegenden Erfindung die akustischen Abstände in den einzelnen Spuren derart gewählt, daß ein angenähert ganzzahliges Vielfaches der halben akustischen Wellenlänge zwischen zwei in einer jeden der Spuren endständigen Reflektorstrukturen für diese Wellenlänge vorliegt. Mit anderen Worten heißt dies, daß hier jede Spur eine Resonator-Cavity zwischen deren Reflektorstrukturen aufweist. Dabei ist hier erfindungsgemäß für die eine Spur eines Spurpaares (wie bei der ersten Variante) eine Frequenz f1 und für die andere Spur desselben eine Frequenz f2 als jeweilige Resonanzfrequenz vorgesehen. Diese Abstimmung erfolgt dadurch, daß in der jeweils einen Spur der Reflektor des einen Endes des Resonators relativ zu dem Reflektor des anderen Endes etwas hinverschoben ist, d. h. die Resonatorlänge etwas kleiner ist, und in der anderen Spur des Paares entsprechend wegverschoben ist , d. h. die Resonatorlänge dagegen etwas größer ist, (nämlich gegenüber einer Anordnung mit der Resonanzfrequenz f0 der Bandmitte). Sinnvollerweise werden (auch hier) Frequenzen f1 und f2 gewählt, die symmetrisch zur Bandmittenfrequenz f0 liegen. Es können auch z. B. vier Spuren mit vier verschiedenen Frequenzen f1 bis f4 vorgesehen sein.

Für das vierspurige Filter empfiehlt es sich, die Frequenzen f1 und f2 bzw. f3 und f4 der Spurenpaare 1/2 bzw. 3/4 symmetrisch zur Bandmittenfrequenz f0 zu wählen. Es würde dann z. B. gelten f4 < f1 < (f0 <) f2 < f3. Andere sinngemäße Verteilungen können aber auch gewählt werden. Auch bei der zweiten Variante ist es erforderlich, daß die Signale benachbarter Frequenzen jeweils 180 ° Phase zueinander haben.

Bei dieser zweiten Variante der Erfindung sind zur Eliminierung des Grundpegels jeweils Spurenpaare, d. h. ist eine stets gradzahlige Anzahl Spuren vorhanden. Die jeweils zwei Spuren eines Paares kompensieren in ihrem zusammengeschalteten Ausgang die Ausgangssignale der direkten Eingangswandler-Ausgangswandler-Übertragung (die von einem jeden Ausgangswandler der zwei Spuren an diesen Ausgang abgegeben werden.

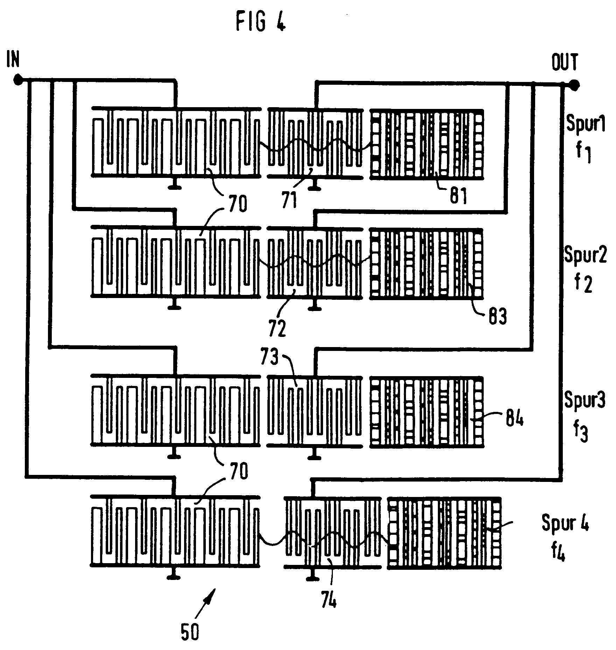

Fig. 4 zeigt eine hinsichtlich der Auswahl der einzelnen Oberflächenwellenstrukturen gefundene optimale Lösung für ein Filter 50 entsprechend der zweiten Variante der Erfindung. Die Figur 4 zeigt vier Spuren 1 bis 4, jedoch ist ein erfindungsgemäßes Filter bereits mit zwei Spuren als Spurenpaar realisierbar, z. B. mit allein den Spuren 1 und 2 mit den Frequenzen f1 und f2.

Als Eingangswandler 70 sind hier vorteilhafterweise dem Prinzip nach an sich bekannte Einphasen-Unidirektionalwandler verwendet, die als SPUDTs bekannt sind. Charakteristisch für diese SPUDTs ist, daß sie aufgrund ihres internen Aufbaus, d. h. der Wahl und Anordnung der interdigital angeordneten Finger des Wandlers eine unidirektionale Abstahlcharakteristik haben. Ein jeder der SPUDT-Wandler 70 strahlt nahezu die gesamte akustische Leistung nach der einen, durch den Aufbau vorgegebenen Richtung ab. Ein SPUDT enthält wandlerintern angeordnete Reflektorstreifen, die hier gleichzeitig dazu benutzt werden, um den jeweiligen Resonanzraum nach der nichtabstrahlenden Richtung hin zu begrenzen. Ein solcher SPUDT-Wandler ist hier gleichzeitig auch als Reflektor des einen Endes der Resonatorlänge 1 für die von ihm erzeugte akustische Welle benutzt.

In Richtung der Abstrahlrichtung des SPUDT-Eingangswandlers ist inline der (jeweilige) Ausgangswandler 71 (bis 74) angeordnet. Weiter folgt in dieser Abstrahlrichtung hinter dem Ausgangswandler die schon oben erwähnte (jeweilige) Reflektorstruktur 81 (bis 84) mit 180° (Rück-) Reflexion. Vorzugsweise ist der (jeweilige) Ausgangswandler als reflexionsfreier (z. B. Splitfinger-) Wandler ausgeführt.

Wie an sich vom Filter der DE-OS 39 42 140 bekannt, haben Eingangswandler 70 und Ausgangswandler 71/72 bzw. 73/74 des jeweiligen Spurpaares 1/2 bzw. 3/4 einen effektiven Abstand voneinander, der so bemessen ist, daß der Ausgangswandler auf direktem Wege aus dem ihm benachbarten Eingangswandler zwar ein akustisches Signal empfangen und in ein elektrisches Signal umwandeln kann, daß aber diese Umwandlung für die beiden Spuren zusammengenommen derart gegenphasig ist, daß an dem zusammengeschalteten elektrischen Ausgang der beiden Ausgangswandler die in den beiden Spuren in dieser Weise direkt übertragenen Signale sich gegenseitig aufheben, d.h. elektrisch interferieren. Eine direkte nichtselektive Wandler-Wandlerübertragung zwischen Eingang- und Ausgang des Spurenpaares findet somit nicht statt.

Die vom Eingangswandler 70 der jeweiligen Spur durch dessen (vorzugsweise nicht reflektierenden) Ausgangswandler 71 (bis 74) hindurch in die Reflektorstruktur 81 (bis 84) der Spur gelangende akustische Welle erfährt dort eine 180°-Reflexion. Das dort reflektierte Wellensignal gelangt, nunmehr jedoch von der Seite der Reflektorstruktur 81 bis 84 her, d. h. nach Reflexion durch die Reflektorstruktur, in den Ausgangswandler 71 (bis 74) der betreffenden Spur. Im bekannten Stand der Technik ist vorgesehen, daß diese akustische Signalübertragung vom Ausgangswandler zur dort für alle Spuren gleichen Reflektorstruktur und zurück zum Ausgangswandler phasengleich in beiden Spuren (eines Spurenpaares) erfolgt. Dies bedingt dort einen Abstand Wandler-Reflektor gleich einem ungradzahligen Vielfachen von einer Viertelwellenlänge.

Bei der Erfindung ist im Ergebnis, aber aus ganz anderem Grunde, ebenfalls vorgesehen, daß für die Spuren untereinander der Abstand zwischen (den beiden einander gegenüberliegenden jeweils äußersten (Split-)Fingern bzw. Streifen von) Ausgangswandler und Reflektorstruktur unterschiedlich bemessen ist, jedoch nur um jeweils einen Bruchteil einer Viertelwellenlänge. Und zwar ist der Abstands- Unterschied 2 x Δ jeweils entgegengesetzt gleich groß mit +Δ und -Δ additiv zum oben beschriebenen Abstand auf (die) zwei Spuren eines jeweiligen Spurenpaares verteilt. Mit dieser erfindungsgemäßen Maßnahme wird erreicht, daß die vom Eingangswandler der jeweiligen Spur zunächst breitbandig abgestrahlte akustische Welle in der einen Spur mit der Frequenz f1 und in der anderen Spur mit der Frequenz f2 in Eigenresonanz kommt. Für z. B. 4 Spuren (Fig. 4) wählt man z. B. -Δ für Spur 1 mit f1, +Δ für Spur 2 mit f2, -Δ' für Spur 4 mit f4 und +Δ' für Spur 3 mit f3.

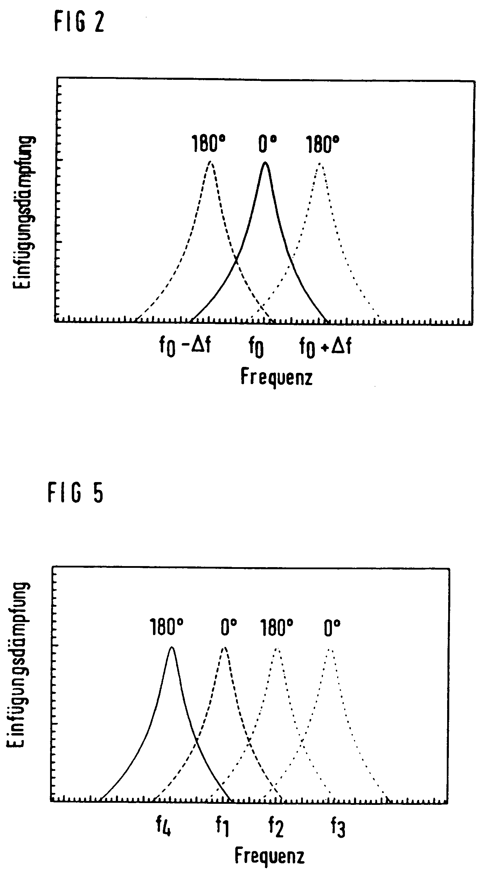

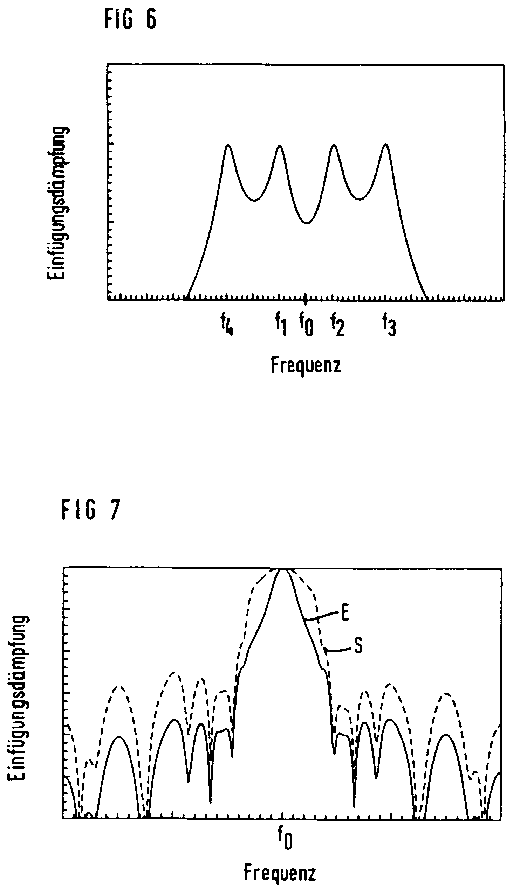

Bei der vorliegenden Erfindung ist also völlig anders als nach der DE-OS 39 42 140 mit den erfindungsgemäßen Maßnahmen erreicht, daß zwischen den beiden endständigen Reflektoren, nämlich dem reflektierenden Eingangswandler 70 und dem Reflektor 81 (bis 84) sich eine stehende akustische Welle der Frequenz f1 (bis f4) ausbildet. Der Ausgangswandler 71 (bis 74) der Spur 1 (der Spuren 2, 3 und 4) koppelt aus der stehenden Welle das Ausgangssignal der (jeweiligen) Spur aus und liefert dies an den gemeinsammen Ausgang OUT. Jeder Ausgangswandler koppelt dabei aus der stehenden akustischen Welle der Spur ein selektives Ausgangssignal mit schmalbandiger, hoher Resonanzspitze der Frequenzen f1 bis f4 aus. Aufgrund der unterschiedlichen Resonatorlängen der einzelnen Spuren ergeben sich wie schon oben erwähnt, für das Filter 50 der Figur 4 die in Figur 5 gezeigten vier Resonanzspitzen. Die Figur 6 zeigt die Addition dieser Resonanzspitzen im Ausgang OUT.

Aufgrund der Eliminierung des Grundpegels für Spurenpaare (Spur 1 und Spur 2; Spur 3 und Spur 4) ergibt sich für das Filter 50 der in Fig. 6 gezeigte bandfilterförmige Verlauf des Durchlaßverhaltens bzw. der Einfügungsdämpfung, wobei durch Wahl der Abstände der Frequenzen f1 bis f4 ein günstiger angenähert rechteckiger Verlauf mit sehr steilen Flanken zu erreichen ist. Die Figur 7 zeigt mit stark verkleinertem Maßstab auf Abszisse und Ordinate mit der ausgezogenen Kurve E den Verlauf der Einfügungsdämpfung des erfindungsgemäßen Filters 50 nach Fig. 4 mit seinen Nebenzipfeln.

Der gestrichelt wiedergegebene Verlauf S gibt die Einfügungsdämpfung für ein vergleichbares Filter nach der obengenannten DE-OS 39 42 140 wieder. Deutlich sind die Vorteile der Erfindung hinsichtlich verringerter Bandbreite, d. h. erhöhter Selektivität und geringeren Grundpegels der Nebenzipfel zu erkennen.

Wie in Fig. 5 angegeben, haben benachbarte Frequenzen jeweils 180° Phasenverschiebung. Wie aus Fig. 4 zu ersehen, ist dies dadurch erreicht, daß die Ausgangswandler 71 und 72 phasenentgegengesetzt miteinander verbunden sind. Das Gleiche gilt auch für die Beziehung zwischen den Ausgangswandlern 72 und 73. Auch der Ausgangswandler 74 ist phasenentgegengesetzt dem Ausgangswandler 71 parallel geschaltet.

Zur Spur 4 und zum Ausgangswandler 74 ist noch zu erwähnen, daß in der Spur 4 die zur Eliminierung des Grundpegels vorgesehene phasenentgegengesetzte Parallelschaltung der Ausgangswandler 73 und 74 durch einen Abstandsunterschied λ/2 des Abstandes zwischen Eingangswandler 70 und Ausgangswandler 73 bzw. 74 erzielt ist. Wegen dieses λ/2 größeren Abstandes ist auch der Reflektor 84 in der Spur 4 um das entsprechende Maß der 1/2 Wellenlänge nach rechts verschoben. Auf die Resonanz in der Spur 4 hat dies keinen Einfluß.

Bei der Erfindung können die Reflektoren 81 bis 84 identische Reflektoren sein. Vorteilhafter ist jedoch, die einzelnen Reflektoren 81 bis 84 mit jeweils solchen Streifenabständen innerhalb des Reflektors auszuführen, die der jeweiligen Frequenz f1 bis f4 der betreffenden Spur entspricht. Das Gleiche für den jeweiligen auch als Resonator verwendeten Eingangswandler der einzelnen Spuren 1 bis 4 vorzusehen führt zu besserer Symmetrie, kann aber den Grundpegel erhöhen.

Die Reflektoren 81 bis 84 haben wie in Fig. 4 dargestellt in Längsrichtung unterbrochene Reflektorfinger. In der Figur 4 sind im übrigen innerhalb der Reflektoren 81 bis 84 abwechselnd Normalfinger und Splitfingerpaare vorgesehen. Die Positionierung der Ausgangswandler 71 bis 74 ist gegenüber dem jeweiligen Eingangswandler 70 in bekannter Weise im Hinblick auf die Eliminierung des Grundpegels entsprechend der obengenannten DE-OS festgelegt. Der jeweilige Abstand zwischen Ausgangswandler 71 bis 74 und Reflektorstruktur 81 bis 84 enthalt den schon oben ausführlich erwähnten Abstandsunterschied Δ bzw. Δ' für die Resonanzabstimmung der jeweiligen Spur. Wie schon oben angegeben, ist die Größe Δ, Δ' klein gegenüber einem Viertel der Wellenlänge und ist in der Fig. 4 gegenüber dem konstruktiv erforderlichen Mindestabstand nicht zu erkennen. Dieser konstruktiv bedingte Abstand wird zweckmäßigerweise, und zwar zwischen den einander gegenüberliegenden äußeren Kanten der einander gegenüberliegenden Finger von Ausgangswandler und Reflektor, zu n λ/2 bemessen. Figur 1 zeigt ein entsprechendes Bild, in dem dieser Abstand zwischen dem Ausgangswandler 31 und dem benachbarten Reflektor 3 halbe Wellenlängen groß bemessen ist. Wie aus Fig. 1 zu ersehen fallen dann die Maxima der sich bildenden stehenden Welle mit den Wandlerschwerpunkten der einzelnen Splitfingerpaare des Ausgangswandlers zusammen. Diese Positionierung ist aber nicht besonders kritisch. Abweichungen davon führen lediglich zu verringerter Auskopplung aus der stehenden Welle.

## Patentansprüche

1. Oberflächenwellen-Resonatorfilter mit Substrat mit Anordnung von Oberflächenwellenstrukturen in wenigstens zwei Spuren in jeweils inline-Zueinanderanordnung,
mit in jeder Spur (1 bis 3; 4) einem Eingangswandler (30; 130, 130'; 70), einem Ausgangswandler (31 bis 33; 131, 131', 132, 132'; 71 bis 74) und zwei Reflektorstrukturen (41 bis 43; 70, 81 bis 84),
mit Parallelschaltung der Eingangswandler der Spuren als Eingang (IN) und
mit Parallelschaltung der Ausgangswandler der Spuren als Ausgang (OUT), wobei die Anordnung dieser Reflektorstrukturen für eine jeweilige Spur (1 bis 4) einen Resonator (Cavity) für eine jeweilige Frequenz (f1 bis f3; f4) bilden und sich die Frequenzen (f1 bis f4) der einzelnen Spuren (1 bis 4) voneinander um eine Mittenfrequenz (f0) herum verteilt derart voneinander unterscheiden, daß die mit den einzelnen Ausgangswandlern der Spuren (1 bis 4) ausgekoppelten Signale (f1, f2, f3, f4) zusammengenommen einen Bandfilterverlauf der Einfügungsdämpfung (Fig. 6) ergeben, wobei jeweils zwei Ausgangswandler, die Signale jeweils benachbarter Frequenzen auskoppeln, derart positioniert/elektrisch miteinander verbunden sind, daß ihre ausgekoppelten Signale 180°-Phasenverschiebung zueinander aufweisen (Fig. 2 und 5).

2. Oberflächenwellenfilter nach Anspruch 1, mit in der jeweiligen Spur paarweise nebeneinander angeordneten Eingangswandlern und Ausgangswandlern (130, 131'; 130', 131; 130, 132'; 130', 132),
wobei die Eingangswandler eines jeden Paares Eingangswandler/Ausgangswandler einer Spur in Parallelschaltung sind und diese Parallelschaltungen aller Spuren als gemeinsamer Eingang wiederum parallel geschaltet sind und
wobei die Ausgangsswandler eines jeden Paares Eingangswandler/Ausgangswandler einer Spur in Parallelschaltung sind und diese Parallelschaltungen aller Spuren als gemeinsamer Ausgang wiederum parallel geschaltet sind

3. Oberflächenwellenfilter nach Anspruch 1,
wobei der Transfer der akustischen Welle zwischen dem Eingangswandler (70) und dem Ausgangswandler (71; 73) der einen Spur (1; 3) gegenüber dem entsprechenden Transfer in einer anderen Spur (2; 4) eines Spurpaares (1/2; 3/4) um ein ungradzahliges Vielfaches der halben Wellenlänge/um 180°-Phase hinsichtlich des bei gleichem Eingangssignal für beide Spuren (1, 2; 3, 4) vom jeweiligen Ausgangswandler (71 bis 74) abgegebenen elektrischen Ausgangssignals voneinander verschieden ist, so daß sich im Ausgang (OUT) die Signale des Eingangswandler-Ausgangswandler-Transfer für diese paarweisen Spuren (1, 2; 3, 4) gegeneinander aufheben und
wobei die Abstände/die Weglängen der akustischen Welle zwischen den einander gegenüberliegenden Rändern des Ausgangswandlers (71 bis 74) und der dem betreffenden Ausgangswandler benachbart angeordneten Reflektorstruktur (81 bis 84) der jeweiligen Spuren (1 bis 4) sich derart um Bruchteile einer viertel Wellenlänge voneinander unterscheiden, daß sich für die Spuren (1 bis 4) die jeweiligen voneinander verschiedenen Resonanzfrequenzen (f1 bis f4) ergeben.

4. Oberflächenwellenfilter nach Anspruch 3,
bei dem die Ausgangswandler zweier ein Paar bildender Spuren (1, 2) elektrisch einander entgegengesetzt gepolt parallel geschaltet sind.

5. Oberflächenfilter nach Anspruch 3 oder 4,
bei dem die beiden Ausgangswandler (73, 74) zweier ein Paar bildender Spuren (3, 4) in der jeweiligen Spur gegenüber dem jeweiligen Eingangswandler (70) einen um ein ungradzahliges Vielfaches der halben Wellenlänge unterschiedlichen Abstand haben und demzufolge zueinander phasenentgegengesetzten direkten Eingangswandler-Ausgangswandler-Transfer aufweisen.

6. Oberflächenwellenfilter nach einem der Ansprüche 3 bis 5, mit Eingangswandlern (70), die außerdem Reflektorstrukturen sind.

7. Oberflächenwellenfilter nach Anspruch 6 mit SPUDT-Eingangswandlern.
